# EUROPÄISCHE PATENTSCHRIFT

(11) **EP 0 710 983 B1**
(45) Veröffentlichungstag und Bekanntmachung des Hinweises auf die Patenterteilung: **28.02.2001**
(21) Anmeldenummer: 95117337.6
(22) Anmeldetag: 03.11.1995
(51) Int. Cl.: H01L 25/11

(54) **Brücken-Modul**
Bridge module
Module à pont

(30) Priorität: 07.11.1994 DE 4439632
(43) Veröffentlichungstag der Anmeldung: 08.05.1996
(73) Patentinhaber: eupec Europäische Gesellschaft für Leistungshalbleiter mbH & Co. KG, 59581 Warstein (DE)
(72) Erfinder: Schulze, Gerhard, Dipl.-Ing., D-59557 Lippstadt (DE); Spanke, Reinhold, Dipl.-Ing., D-59909 Bestwig (DE); Sommer, Karl-Heinz, Dr. rer.nat., D-59581 Warstein (DE)
(74) Vertreter: Zedlitz, Peter, Dipl.-Inf.

(56) Entgegenhaltungen:
- EP-A- 0 584 668
- JP-A- 7 099 285
- EUPEC: "EUPEC Katalog IGBT-Powerblocks; IGBT-Modules" 1995 , EUROPÄISCHE GESELLSCHAFT FÜR LEISTUNGSHALBLEITER MBH + CO KG , WARSTEIN-BELECKE, DEUTSCHLAND XP002041697 * Seite 183 - Seite 184; Abbildungen 6-10,12 *
- PATENT ABSTRACTS OF JAPAN vol. 011, no. 083 (E-489), 13.März 1987 & JP 61 237461 A (TOSHIBA CORP), 22.Oktober 1986,
- PATENT ABSTRACTS OF JAPAN vol. 006, no. 123 (E-117), 8.Juli 1982 & JP 57 052386 A (HITACHI LTD), 27.März 1982,
- PATENT ABSTRACTS OF JAPAN vol. 003, no. 082 (E-123), 14.Juli 1979 & JP 54 060560 A (OKI ELECTRIC IND CO LTD), 16.Mai 1979,
- PATENT ABSTRACTS OF JAPAN vol. 007, no. 186 (E-193), 16.August 1983 & JP 58 089062 A (HITACHI SEISAKUSHO KK), 27.Mai 1983,

## Beschreibung

Die Erfindung bezieht sich auf ein Brücken-Modul mit mindestens zwei Brückenzweigen und mit mindestens zwei steuerbaren Halbleiterschaltern pro Brückenzweig, mit einer metallenen Bodenplatte, mit der elektrisch isolierende und thermisch leitende, mit Leiterbahnen versehene Substrate verbunden sind, auf denen die Halbleiterschalter elektrisch leitend befestigt sind, mit einem Gehäuse, das mindestens zwei Wechselstromanschlüsse und Gleichstromanschlüsse hat, mit mit den Wechselstromanschlüssen und den Halbleiterschaltern verbundenen Wechselstrom-Anschlußleitern und mit mit den Gleichstromanschlüssen und den Halbleiterschaltern verbundenen Gleichstrom-Anschlußleitern.

Solche Brücken-Module, z.B. für drei Phasen, sind im Handel erhältlich. Man vergleiche z. B. den eupec Katalog IGBT-Module Druck Nr.: 404W07/90. Bei den dort gezeigten Modulen sind die Gleichstromanschlüsse ein- und derselben Polarität jeweils im Gehäuse zusammengefaßt und über je einen Anschlußleiter mit auf dem Gehäuse sitzenden Gleichstromanschlüssen verbunden. Damit sind die Gleichstromleitungen von den Gleichstromanschlüssen zu den einzelnen Brückenzweigen unterschiedlich lang. Diese Unsymmetrie innerhalb des Moduls schränkt den ausnutzbaren Strom- und Spannungsbereich der Halbleiterschalter ein, da die Eigenschaften des Moduls durch den Brückenzweig mit der größten parasitären Induktivität bestimmt sind.

Ziel der Erfindung ist eine Verbesserung der elektrischen Eigenschaften durch Symmetrie des Aufbaus.

Dieses Ziel wird dadurch erreicht, daß jeder Brückenzweig zwei Gleichstrom-Anschlußleiter und zwei Gleichstromanschlüsse hat und daß alle Gleichstromanschlüsse ein- und derselben Polarität durch außerhalb des Gehäuses liegende, einander benachbarte Leiter, untereinander verbindbar sind.

Weiterbildungen der Erfindung sind Gegenstand der Unteransprüche.

Die Erfindung wird anhand eines Ausführungsbeispiels in Verbindung mit den Figuren 1 bis 3 näher erläutert. Es zeigen
- Figur 1: eine Aufsicht auf ein Brücken-Modul nach der Erfindung,
- Figur 2: eine Aufsicht auf den inneren Aufbau des Moduls nach Figur 1 in vereinfachter Darstellung und
- Figur 3: eine detallierte Darstellung eines der Halbleiterschalter des Moduls.

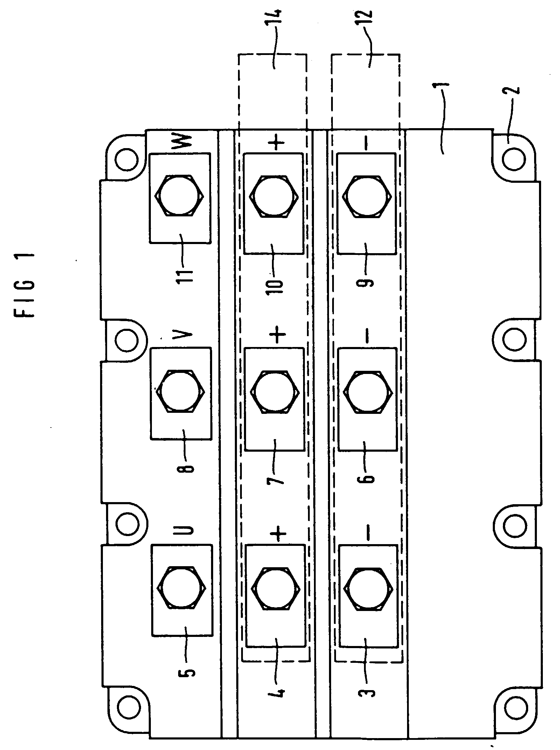

Das Brücken-Modul nach Figur 1 ist in einem Gehäuse 1 eingeschlossen, das auf einer metallenen Bodenplatte 2 montiert ist. Zwischen Gehäuse und Bodenplatte ist eine Dreiphasenbrücke mit drei Leistungshalbleiterzweigen mit jeweils zwei Halbleiterschaltern untergebracht. Die Gleichstromanschlüsse der Brückenzweige mit negativer Polarität sind mit 3, 6 und 9 bezeichnet. Die Gleichstromanschlüsse mit positiver Polarität tragen die Bezugsziffern 4, 7 und 10. Die Wechselstromanschlüsse für die Phasen U, V und W sind mit 5, 8 und 11 bezeichnet. Die Wechselstromanschlüsse 5, 8 und 11 führen in bekannter Weise zu den Mittelabgriffen der Brückenzweige. Die Gleichstromanschlüsse sind über Gleichstrom-Anschlußleiter mit den Halbleiterschaltern verbunden. Für jeden Brückenzweig sind zwei Gleichstromanschlüsse 4, 3 bzw. 7, 6 bzw. 10, 9 vorgesehen. Die Gleichstromanschlüsse mit negativer Polarität 3, 6 und 9 werden durch eine außerhalb des Gehäuses liegende Lasche 12 elektrisch miteinander verbunden. Ebenso werden die Gleichstromanschlüsse 4, 7 und 10 durch eine außerhalb des Gehäuses liegende Lasche 14 elektrisch miteinander verbunden. Diese Verbindung kann entweder vom Hersteller oder auch vom Anwender hergestellt werden. Die beiden Laschen 12, 14 für den Gleichstrom sind einander benachbart angeordnet, dadurch wird die Induktivität auch für den äußeren Gleichstromkreis niedrig gehalten.

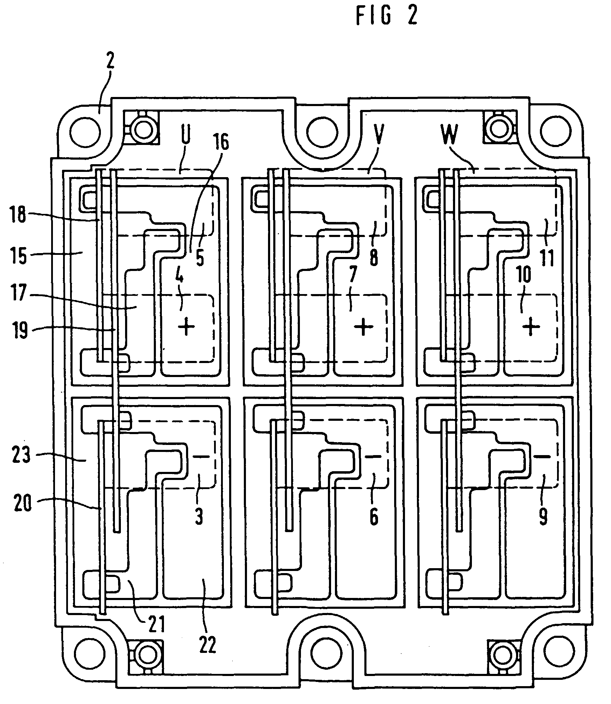

Der innere Aufbau des Gleichrichterbrücken-Moduls nach Figur 1 ist in Figur 2 in einem anderen Maßstab vereinfacht dargestellt. Erläutert wird der Aufbau lediglich für den Brückenzweig der Phase U, der Aufbau der Phasen V und W ist dem des Zweigs U identisch.

Auf der metallenen Bodenplatte 2 sind für die Phase U thermisch leitende und elektrisch isolierende Substrate 15 und 23 befestigt. Diese bestehen üblicherweise aus Aluminiumoxid Al₂O₃ oder Aluminiumnitrid AlN. Das Substrat 15 ist auf der Oberseite mit Leiterbahnen 16, 17 versehen. Auf der Leiterbahn 16 ist ein Halbleiterschalter angeordnet. Er kann z. B. aus einem IGBT bestehen, der mit seiner Kollektorseite mit dem Substrat 16 verlötet wird. Die Emitterseite des IGBT ist z. B. über Bonddrähte mit der Leiterbahn 17 verbunden.

Die Leiterbahn 16 ist mit einem Gleichstrom-Anschlußleiter 18 verbunden, die Leiterbahn 17 mit einem Wechselstrom-Anschlußleiter 19. Außerhalb des Gehäuses ist der Gleichstrom-Anschlußleiter mit dem Gleichstromanschluß 4 verbunden. Der Wechselstrom-Anschlußleiter 19 ist oberhalb des Gehäuses mit dem Wechselstromanschluß 5 verbunden. Die Anschlüsse 4 und 5 sind der Übersichtlichkeit halber gestrichelt dargestellt.

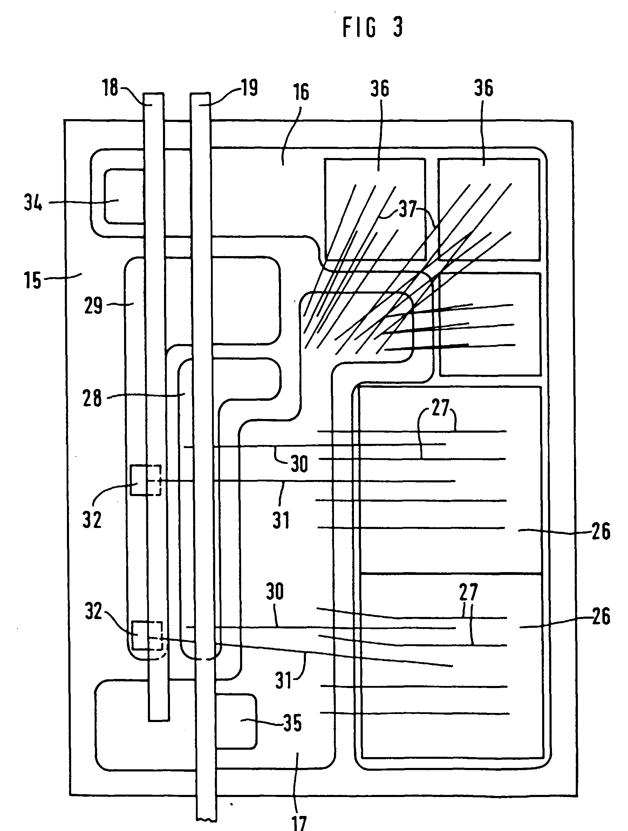

Entsprechend trägt das Substrat 23 Leiterbahnen 21 und 22. Der zweite Halbleiterschalter des Brückenzweiges der Phase U ist auf der Leiterbahn 22 angeordnet. Ist der Halbleiterschalter ein IGBT, so ist er ebenfalls mit seiner Kollektorseite auf der Leiterbahn 22 aufgelötet. Die Emitterseite des IGBT ist z. B. wieder über Bonddrähte mit der Leiterbahn 21 verbunden. Die Leiterbahn 21 trägt einen Gleichstrom-Anschlußleiter 20, der auf der Oberseite des Gehäuses mit dem Gleichstromanschlußleiter 3 verbunden ist. Die Leiterbahn 22 ist mit dem Wechselstrom-Anschlußleiter 19 verbunden. Die Halbleiterschalter selbst sowie weitere, z. B. zur Ansteuerung notwendige Leiterbahnen und Verbindungsleiter sind in Figur 2 nicht dargestellt. Hierzu wird auf die Figur 3 verwiesen.

In Figur 3 ist detailliert derjenige Halbleiterschalter gezeigt, der auf dem Substrat 15 aufgebaut ist. Der Halbleiterschalter enthält hier zwei Halbleiterchips 26, z. B. IGBT, die kollektorseitig auf die Leiterbahn 16 aufgelötet sind. Die Emitterseiten der IGBT sind über Bonddrähte 27 elektrisch mit der Leiterbahn 17 verbunden. Auf der Leiterbahn 16 sind außerdem noch Freilaufdioden 36 angeordnet derart, daß ihr Kathodenanschluß mit der Leiterbahn 16 verlötet ist und ihr Anodenanschluß über Bonddrähte 37 mit der Leiterbahn 17 verbunden ist. Die Freilaufdioden 36 sind den IGBT 26 antiparallel geschaltet.

Zusätzlich zu den Leiterbahnen 16, 17 sind auf dem Substrat 15 weitere Leiterbahnen 28, 29 vorhanden. Die Leiterbahn 28 ist dabei über Bonddrähte 30 mit den Emitterkontakten der IGBT 26 verbunden. Sie dient als Hilfsemitteranschluß. Die Leiterbahn 29 ist über Bonddrähte 31 mit den Gateanschlüssen der IGBT verbunden. Dabei können zwischen der Leiterbahn 29 und den Bonddrähten 31 noch Widerstände 32 geschaltet sein. Diese dienen in bekannter Weise dazu, das Einschalten der IGBT zu vergleichmäßigen.

Der Gleichstrom-Anschlußleiter 18 ist über einen Fuß 34 mit der Leiterbahn 16 verbunden, der Wechselspannungs-Anschußleiter 19 über einen Fuß 35 mit der Leiterbahn 17. Die Leiterbahnen 28 und 29 sind ebenfalls über Anschlußleiter mit dem Gehäuseäußeren verbunden. Diese Anschlußleiter wurden der besseren Übersichtlichkeit halber weggelassen.

Der untere Halbleiterschalter des Brückenzweigs U ist identisch aufgebaut. Auf eine gesonderte Darstellung und Beschreibung wird daher verzichtet.

Zur Verbesserung der elektrischen Eigenschaften sind diejenigen Anschlußleiter jedes Halbleiterschalters, die den Hin- und Rückstrom (Laststrom) führen, bandförmig ausgeführt und dicht beieinander angeordnet. In der Anordnung nach Figur 2 sind dies für den oberen Brückenzweig die Anschlußleiter 18 und 19 und für den unteren Brückenzweig die Anschußleiter 20 und 19.

Die Erfindung wurde anhand einer Dreiphasenbrücke beschrieben. Selbstverständlich kommt die Erfindung auch für eine Einphasenbrücke in Betracht. Anstelle der im Ausführungsbeispiel beschriebenen Parallelschaltungen von zwei IGBT können bei entsprechender Ausgestaltung der Leiterbahnen auch drei oder mehr IGBT einander parallel geschaltet sein. Anstelle der IGBT können auch Leistungs-MOSFET eingesetzt werden. Die Erfindung ist gleichermaßen für Wechselrichter- als auch für Gleichrichter-Module anwendbar.

## Patentansprüche

1. Brücken-Modul mit mindestens zwei Brückenzweigen und mindestens zwei steuerbaren Halbleiterschaltern pro Brückenzweig, mit einer metallenen Bodenplatte, mit der elektrisch isolierende und thermisch leitende, mit Leiterbahnen versehene Substrate verbunden sind, auf denen die Halbleiterschalter elektrisch leitend befestigt sind, mit einem Gehäuse, das mindestens zwei Wechselstromanschlüsse und vier Gleichstromanschlüsse hat, mit mit den Wechselstromanschlüssen und den Halbleiterschaltern verbundenen Wechselstrom-Anschlußleitern und mit mit den Gleichstromanschlüssen und den Halbleiterschaltern verbundenen Gleichstrom-Anschlußleitern,
**dadurch gekennzeichnet**, daß jeder Brückenzweig (U, V, W) zwei Gleichstrom-Anschlußleiter (18, 20) und zwei Gleichstromanschlüsse (3, 4; 6, 7; 9, 10) hat und daß alle Gleichstromanschlüsse ein- und derselben Polarität durch außerhalb des Gehäuses (1) liegende, einander benachbarte Leiter untereinander verbindbar sind.

2. Brücken-Modul nach Anspruch 1,
**dadurch gekennzeichnet**, daß die Anschlußleiter jedes Brückenzweiges bandförmig ausgebildet sind und daß die den Hin- und Rückstrom führenden Anschlußleiter (18, 19; 20, 19) jeweils dicht beieinander angeordnet sind.

3. Brücken-Modul nach Anspruch 1 oder 2,
**dadurch gekennzeichnet**, daß es drei Brückenzweige hat.

4. Brücken-Modul nach Anspruch 1, 2 oder 3,
**dadurch gekennzeichnet**, daß die Halbleiterschalter aus einander parallel geschalteten Halbleiterbauelementen (26) bestehen.

5. Brücken-Modul nach einem der Ansprüche 1 bis 4,
**dadurch gekennzeichnet**, daß den Halbleiterschaltern Freilaufdioden (36) antiparallel geschaltet sind.

## Claims

1. Bridge module having at least two bridge paths and at least two controllable semiconductor switches per bridge path, having a metal baseplate to which are connected electrically insulating and thermally conductive substrates which are provided with conductor tracks and on which the semiconductor switches are fixed in an electrically conductive manner, having a housing which has at least two AC connections and four DC connections, having AC connecting conductors connected to the AC connections and to the semiconductor switches, and having DC connecting conductors connected to the DC connections and to the semiconductor switches, characterized in that each bridge path (U, V, W) has two DC connecting conductors (18, 20) and two DC connections (3, 4; 6, 7; 9, 10), and in that all the DC connections of one and the same polarity can be interconnected by mutually adjacent conductors lying outside the housing (1).

2. Bridge module according to Claim 1,
characterized in that the connecting conductors of each bridge path are designed in strip form, and in that the connecting conductors (18, 19; 20, 19) carrying the forward and reverse current are in each case arranged close together.

3. Bridge module according to Claim 1 or 2,
characterized in that it has three bridge paths.

4. Bridge module according to Claim 1, 2 or 3,
characterized in that the semiconductor switches comprise semiconductor components (26) connected in parallel with one another.

5. Bridge module according to one of Claims 1 to 4,
characterized in that freewheeling diodes (36) are reverse-connected in parallel with the semiconductor switches.

## Revendications

1. Module à pont avec au moins deux branches de pont et, par branche de pont, avec au moins deux commutateurs statiques qui peuvent être commandés, avec une plaque de base en métal, à laquelle sont reliés des substrats isolés électriquement et conducteurs de la chaleur, qui sont munis de pistes conductrices et sur lesquels sont fixés les commutateurs statiques, conducteurs de l'électricité, avec un coffret qui comporte au moins deux bornes de raccordement à courant alternatif et quatre bornes de raccordement à courant continu, avec des conducteurs de raccordement à courant alternatif reliés aux bornes de raccordement à courant alternatif et aux commutateurs statiques et avec des conducteurs de raccordement à courant continu reliés aux bornes de raccordement à courant continu et aux commutateurs statiques
**caractérisé par le fait** que chaque branche de pont (U, V, W) comporte deux conducteurs de raccordement à courant continu (18, 20) et deux bornes de raccordement à courant continu (3, 4; 6, 7; 9, 10) et que toutes les bornes de raccordement à courant continu d'une seule et même polarité peuvent être raccordées entre elles grâce à des conducteurs voisins les uns des autres se trouvant à l'extérieur du coffret (1).

2. Module à pont selon la revendication 1
**caractérisé par le fait** que les conducteurs de raccordement de chaque branche du pont sont conçus sous forme de ruban et que les conducteurs de raccordement (18, 19; 20, 19), qui sont parcourus par le courant aller et le courant inverse, sont disposés tout près les uns des autres.

3. Module à pont selon la revendication 1 ou 2
**caractérisé par le fait** qu'il a trois branches de pont.

4. Module à pont selon la revendication 1, 2 ou 3
**caractérisé par le fait** que les commutateurs statiques se composent de composants semi-conducteurs (26) connectés en parallèle les uns par rapport aux autres.

5. Module à pont selon l'une des revendications 1 à 4
**caractérisé par le fait** que des diodes roue libre (36) sont connectées en anti-parallèle sur les commutateurs statiques.
